# EUROPEAN PATENT APPLICATION

(11) **EP 3 832 329 A1**
(43) Date of publication of application: **09.06.2021**
(21) Application number: 19844218.8
(22) Date of filing: 23.07.2019
(51) Int. Cl.: G01R 31/389, G01R 27/02, H01M 10/48, H02J 7/00

(54) **BATTERY IMPEDANCE MEASURING DEVICE**

(30) Priority: 31.07.2018 JP 2018143104
(71) Applicant: Nidec-Read Corporation, Kyoto-shi, Kyoto 615-0854 (JP)
(72) Inventor: GUNJI Keita, Kyoto-shi, Kyoto 615-0854 (JP)
(74) Representative: Viering, Jentschura & Partner mbB Patent- und Rechtsanwälte
(86) International application number: PCT/JP2019/028792
(87) International publication number: WO 2020/026888

(57) **Abstract**

A battery impedance measuring device 1 includes a connection circuit unit 7 that includes a terminal Tp detachable from a charging terminal TCp for charging a secondary battery B1, a terminal Tm detachable from a charging terminal TCm for charging the secondary battery B1, a capacitor C1 connected to the terminal Tp, and a capacitor C2 connected to terminal Tm, and a main body unit 5 that includes an AC signal supply unit 51 that supplies an AC signal to the secondary battery B1 via the capacitors C1 and C2, and a measurement unit 52 that detects at least one of a signal obtained from the secondary battery B1 via the terminal Tp and the capacitor C1 and a signal obtained from the secondary battery B1 via the terminal Tm and the second capacitor and measures impedance of the secondary battery B1 based on the detected signal.

## Description

### TECHNICAL FIELD

The present invention relates to a battery impedance measuring device that measures battery impedance.

### BACKGROUND ART

Conventionally, a storage battery deterioration diagnosis device is known which includes an impedance measurement unit that applies a signal at a diagnostic frequency to a storage battery to measure impedance, and a deterioration diagnosis unit that performs deterioration diagnosis on the storage battery by collating the impedance measured by the impedance measurement unit are provided (for example, refer to Patent Literature 1).

### CITATIONS LIST

### PATENT LITERATURE

Patent Literature 1: JP 2017-106889 A

### SUMMARY OF INVENTION

By the way, there is a need to measure the impedance of a power battery of an electric motor vehicle. However, the power battery of an electric motor vehicle has a very high voltage such as an output voltage of 400 V. Therefore, the measuring device for measuring the impedance of such a battery is required to have higher safety.

An object of the invention is to provide a battery impedance measuring device capable of improving safety.

A battery impedance measuring device according to an example of the invention includes a connection circuit unit that includes a positive electrode terminal that is detachable from a positive electrode charging terminal for charging a secondary battery provided outside, a negative electrode terminal that is detachable from a negative electrode charging terminal for charging the secondary battery, a first capacitor that is connected to the positive electrode terminal, and a second capacitor that is connected to the negative electrode terminal, and a main body unit that includes an AC signal supply unit that supplies an AC signal to the secondary battery via the first and second capacitors, and a measurement unit that detects at least one of a signal obtained from the secondary battery via the positive electrode terminal and the first capacitor and a signal obtained from the secondary battery via the negative electrode terminal and the second capacitor, and measures impedance of the secondary battery based on the detected signal.

### BRIEF DESCRIPTION OF DRAWINGS

FIG. 1 is an explanatory diagram conceptually illustrating an example of the configuration of a battery impedance measuring device according to an embodiment of the invention.
FIG. 2 is an explanatory diagram illustrating an operation lever in an OFF posture.
FIG. 3 is a circuit diagram illustrating an example of an electrical configuration of the battery impedance measuring device 1 illustrated in FIG. 1.
FIG. 4 is a circuit diagram illustrating the circuit illustrated in FIG. 3 in a simplified manner.
FIG. 5 is a circuit diagram illustrating a circuit in a simplified manner when an AC signal supply unit is connected to the positive electrode side of a secondary battery.

### DESCRIPTION OF EMBODIMENTS

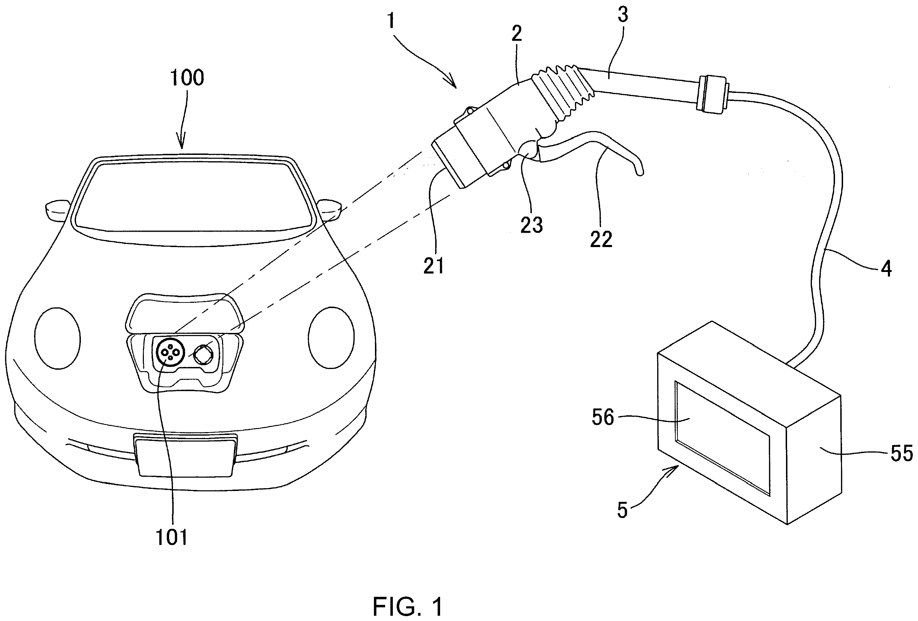

Hereinafter, embodiments of the invention will be described with reference to drawings. Note that components with the same reference numerals in the respective drawings will be the same components and description thereof will be omitted. FIG. 1 is an explanatory diagram conceptually illustrating an example of the configuration of a battery impedance measuring device according to an embodiment of the invention. FIG. 1 illustrates a battery impedance measuring device 1 and an electric motor vehicle 100 equipped with a battery that is an object of impedance measurement by the battery impedance measuring device 1.

The electric motor vehicle 100 is, for example, an electric vehicle (EV), a hybrid vehicle (HV), a plug-in hybrid vehicle (PHV), or the like. The electric motor vehicle 100 includes a charging connector 101 which is provided outside the battery impedance measuring device 1, mounted with a secondary battery B1 described later, and charges the secondary battery B1. A charger for the secondary battery B1 is usually connected to the charging connector 101. The charging connector 101 has, for example, an IEC61851, more specifically, CHAdeMO (registered trademark) system connector shape.

The battery impedance measuring device 1 includes a connection housing 2 having a substantially cylindrical shape, a grip portion 3 which is connected to the connection housing 2 and can be held by a user, a main body unit 5, and a cable 4 which extends from one end of the grip portion 3 and connected to the main body unit 5.

A connector 21 connectable to the charging connector 101 is provided at the tip end of the connection housing 2. The outer surface of the connection housing 2 is covered with an insulating material such as resin. An operation lever 22 extending toward the grip portion 3 is attached to the outer peripheral surface of the connection housing 2.

The operation lever 22 is swingable around a hinge 23 as a fulcrum attached to the outer peripheral surface of the connection housing 2, and can change its posture between an OFF posture that approaches the grip portion 3 and an ON posture that is farther away from the grip portion 3 than the OFF posture. The operation lever 22 illustrated in FIG. 1 illustrates an example of the ON posture.

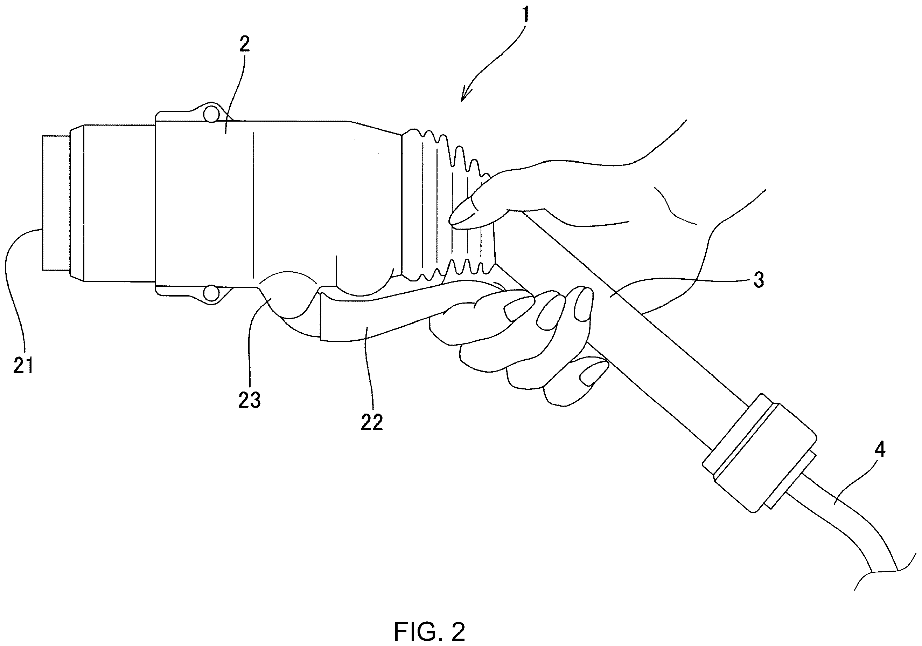

FIG. 2 is an explanatory diagram illustrating the operation lever 22 in the OFF posture. The operation lever 22 is in the OFF posture when the user who holds the grip portion 3 hangs user's finger on the operation lever 22 and holds it, and is in the ON posture when the user releases the finger from the operation lever 22. The operation lever 22 is urged by a spring mechanism (not illustrated) to be in the ON posture when the user releases user's hand from the operation lever 22.

The main body unit 5 includes a substantially cuboid casing 55, and a touch panel display 56 is attached to a wall surface of the casing 55, for example.

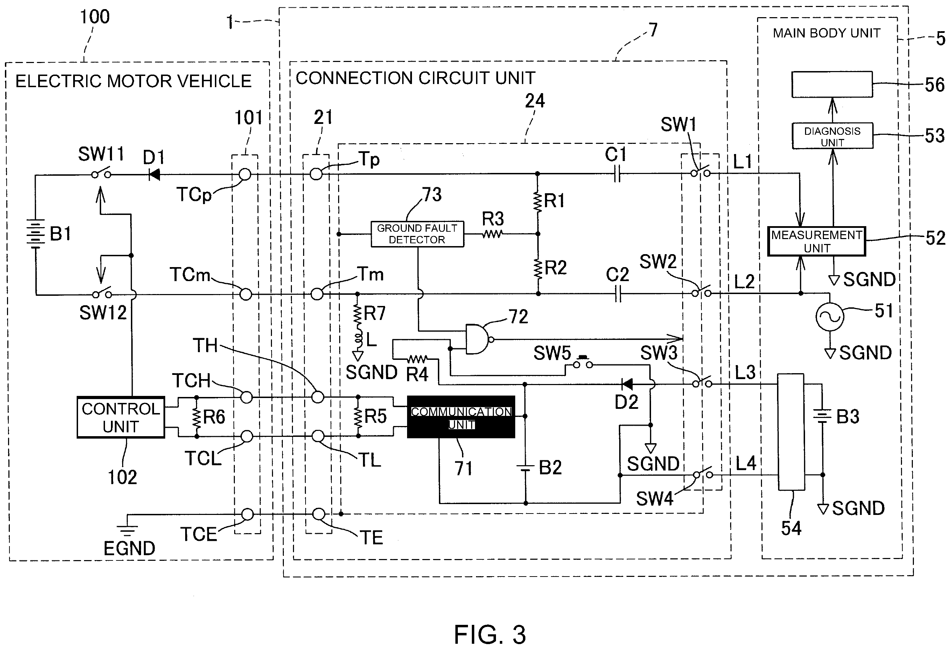

FIG. 3 is a circuit diagram illustrating an example of an electrical configuration of the battery impedance measuring device 1 illustrated in FIG. 1. FIG. 3 illustrates a state in which the connector 21 of the battery impedance measuring device 1 is connected to the charging connector 101 of the electric motor vehicle 100.

The electric motor vehicle 100 includes a charging circuit for the secondary battery B1 that complies with the charging standard defined by IEC61851, more specifically, the charging standard of the CHAdeMO (registered trademark) system.

The electric motor vehicle 100 includes a secondary battery B1 for power, a charging connector 101, a diode D1, switches SW11 and SW12 (switching unit), a control unit 102, and a resistor R6. The charging connector 101 includes a charging terminal TCp (positive electrode charging terminal), a charging terminal TCm (negative electrode charging terminal), communication terminals TCH and TCL, and a ground terminal TCE. In the CHAdeMO (registered trademark) standard connector, the charging terminal TCp corresponds to the sixth pin, the charging terminal TCm corresponds to the fifth pin, the communication terminals TCH and TCL correspond to the eighth and ninth pins, and the ground terminal TCE corresponds to the first pin.

The charging terminal TCp is connected to the anode of the diode D1, the cathode of the diode D1 is connected to the positive electrode of the secondary battery B1 via the switch SW11, and the negative electrode of the secondary battery B1 is connected to the charging terminal TCm via the switch SW12.

The ground terminal TCE is connected to the vehicle body of the electric motor vehicle 100 and grounded to the ground via the tire of the electric motor vehicle 100. In FIG. 3, the earth ground is indicated by an earth ground EGND.

The communication terminals TCH and TCL are connected to the control unit 102, and the termination resistor R6 is connected between communication lines connecting the communication terminals TCH and TCL to the control unit 102.

The switches SW11 and SW12 are switching elements such as relays and contactors that are turned on/off according to a control signal from the control unit 102. The switches SW11 and SW12 are normally off except when the secondary battery B1 is rapidly charged. The switches SW11 and SW12 switch whether to electrically connect the charging terminals TCp and TCm and the secondary battery B1.

The control unit 102 includes a so-called microcomputer including a communication circuit and an arithmetic circuit, an FPGA (Field of Programmable Gate Array), and other integrated circuits. The control unit 102 can execute a communication protocol such as CHAdeMO (registered trademark) (IEC61851). Note that IEC61851 includes charging standards such as GB/T, COMBO1, COMBO2, etc., and the electric motor vehicle 100 may support charging standards other than CHAdeMO (registered trademark). In addition, electric motor vehicle 100 does not necessarily have to comply with the charging standard of IEC61851.

The control unit 102 turns on the switches SW11 and SW12 when receiving a switching command to a quick charging mode from the charger or the battery impedance measuring device 1 connected to the charging connector 101. As a result, the secondary battery B1 can be electrically connected to the charging terminals TCp and TCm, and the secondary battery B1 can be charged by a charging device or measured or inspected by the battery impedance measuring device 1.

The battery impedance measuring device 1 includes a connection circuit unit 7, a main body unit 5, and wirings L1, L2, L3, and L4 connecting the connection circuit unit 7 and the main body unit 5. The wiring L1 corresponds to an example of first wiring, and the wiring L2 corresponds to an example of second wiring.

The connection circuit unit 7 is stored in the connection housing 2, the circuit unit of the main body unit 5 is stored in the casing 55, and the wirings L1, L2, L3, and L4 are stored inside the grip portion 3 and the cable 4.

The battery impedance measuring device 1 may not include the cable 4, the main body unit 5 may not include the casing 55, and the main body unit 5 may be stored in the grip portion 3. Then, the wirings L1 and L2 and the main body unit 5 may be connected in the grip portion 3. If the wirings L1 and L2 and the main body unit 5 are stored in the grip portion 3, the portability of the battery impedance measuring device 1 is improved and the handling becomes easy.

The connection circuit unit 7 does not necessarily have to be stored in the connection housing 2, and the main body unit 5 does not have to be stored in the grip portion 3 or the casing 55.

The connection circuit unit 7 includes a connector 21, a capacitor C1 (first capacitor), a capacitor C2 (second capacitor), a switch SW1 (first switch), a switch SW2 (second switch), switches SW3 and SW4 (third switches), a switch SW5 (open/close switch), a ground fault detector 73 (ground fault detection unit), a NAND gate 72, a communication unit 71, a storage element B2, a diode D2, resistors R1 to R5, an inductor L, and a resistor R7.

The connector 21 includes a terminal Tp (positive electrode terminal), a terminal Tm (negative electrode terminal), communication terminals TH and TL, and a ground terminal TE. In the CHAdeMO (registered trademark) standard, the terminal Tp corresponds to the sixth pin, the terminal Tm corresponds to the fifth pin, the communication terminals TH and TL correspond to the eighth and ninth pins, and the ground terminal TE corresponds to the first pin.

When the connector 21 is connected to the charging connector 101, the terminal Tp is connected to the charging terminal TCp, the terminal Tm to the charging terminal TCm, the communication terminals TH and TL to the communication terminals TCH and TCL, and the ground terminal TE to the ground terminal TCE. Since the terminals Tp and Tm, the communication terminals TH and TL, and the ground terminal TE are connector terminals, it goes without saying that they can be attached to and detached from the charging terminals TCp and TCm, the communication terminals TCH and TCL, and the ground terminal TCE.

The main body unit 5 includes an AC signal supply unit 51, a measurement unit 52, a diagnosis unit 53, a power source B3, a DCDC converter 54, and the touch panel display 56.

The AC signal supply unit 51 supplies an AC signal to the secondary battery B1 via the capacitors C1 and C2. The frequency of the AC signal is, for example, about 10 Hz to 1 MHz. The AC signal supply unit 51 is configured using, for example, an oscillation circuit, a signal generator, a switching circuit, and the like. The AC signal supply unit 51 may output an AC signal having a preset frequency, for example, an AC signal having a frequency according to an instruction from the measurement unit 52.

The measurement unit 52 detects a signal obtained from the secondary battery B1 via the terminal Tp and the capacitor C1 and measures the impedance of the secondary battery B1 based on the detected signal. The measurement unit 52 is configured using, for example, an amplifier, a filter, other circuits for detecting signals, and a microcomputer that executes predetermined arithmetic processing, and the like. As a method of measuring the impedance of the secondary battery B1, the measurement unit 52 can use various known AC impedance measuring methods such as FRA (Frequency Response Analyzer) described in Patent Literature 1, for example.

The diagnosis unit 53 diagnoses the deterioration of the secondary battery B1 based on the impedance measured by the measurement unit 52. For example, when the impedance measured by the measurement unit 52 is larger than a preset reference value, the diagnosis unit 53 may diagnose that the secondary battery B1 is deteriorated. Alternatively, a LUT (look-up table) in which the impedance and the degree of deterioration are associated with each other is stored in the storage unit of the measurement unit 52 in advance, and the diagnosis unit 53 may refer to the LUT to acquire the degree of deterioration associated with the impedance measured by the measurement unit 52 as a diagnosis result. The diagnosis unit 53 causes the touch panel display 56 to display the deterioration diagnosis result obtained in this way, for example.

The power source B3 supplies a charging current to the storage element B2 via the DCDC converter 54 and the switches SW3 and SW4. The power source B3 may be, for example, a battery or a power source circuit. The DCDC converter 54 converts the output voltage of the power source B3 into a voltage suitable for charging the storage element B2.

The switches SW1 to SW4 are switching elements such as relays that are turned on and off according to the output level of the NAND gate 72.

The terminal Tp is connected to the measurement unit 52 via the capacitor C1, the switch SW1, and the wiring L1. The terminal Tm is connected to the AC signal supply unit 51 and the measurement unit 52 via the capacitor C2, the switch SW2, and the wiring L2. In addition, the terminal Tm is connected to a circuit ground SGND of the battery impedance measuring device 1 via a series circuit RL including the resistor R7 and the inductor L.

The terminal Tm is connected to the negative electrode of the secondary battery B1. Since the secondary battery B1 has a high voltage, it is desirable to be insulated from the circuit ground SGND of the battery impedance measuring device 1. However, if the secondary battery B1 is insulated from the circuit ground SGND and is completely floating, there is a possibility that a large difference occurs in the potential difference between the secondary battery B1 and the circuit ground SGND.

When a large potential difference occurs between the secondary battery B1 and the circuit ground SGND, the detection signal obtained from the secondary battery B1 is out of the measurement range of the measurement unit 52 operating in the circuit ground SGND, and the measurement unit 52 may not be able to measure impedance.

Therefore, the terminal Tm, that is, the negative electrode of the secondary battery B1 is connected to the circuit ground SGND by a series circuit of the high-resistance resistor R7 and the inductor L. The resistor R7 causes the negative electrode of the secondary battery B1 to have substantially the same potential as the circuit ground SGND. On the other hand, for the AC signal output from the AC signal supply unit 51, the impedance of the inductor L increases, so that the risk of the AC signal escaping to the circuit ground SGND is reduced.

The connection circuit unit 7 does not necessarily have to include the inductor L, and the terminal Tm may be connected to the circuit ground SGND by the resistor R7. However, it is more preferable to use a series circuit of the resistor R7 and the inductor L in that the attenuation of the AC signal can be reduced. Further, the connection circuit unit 7 may not include both the resistor R7 and the inductor L.

The communication terminals TH and TL are connected to the communication unit 71 via a communication line. The termination resistor R5 is connected between the communication lines. When the connector 21 is connected to the charging connector 101, the communication terminals TH and TL are connected to the communication terminals TCH and TCL, and the communication unit 71 and the control unit 102 are connected via a pair of communication lines.

The communication unit 71 is a communication circuit capable of executing a predetermined communication protocol, for example, a communication protocol such as CHAdeMO (registered trademark) defined in IEC61851. The communication unit 71 is configured by, for example, a microcomputer, an FPGA (Field Programmable Gate Array), and other integrated circuits. When the connector 21 is connected to the charging connector 101, the communication unit 71 sends a switching command to the control unit 102 to switch to the quick charging mode.

The connection of the connector can be detected by various methods. For example, when the communication unit 71 regularly transmits a communication signal to the control unit 102, and obtains a response signal from the control unit 102, the communication unit 71 may detect that the connector 21 is connected to the charging connector 101. Alternatively, when the control unit 102 outputs regularly a communication signal, and the communication unit 71 receives the communication signal, the communication unit 71 may detect that the connector 21 is connected to the charging connector 101. Alternatively, a connection detection circuit (not illustrated) may be provided.

It should be noted that the switching command may be any command as long as it is a command for turning on the switches SW11 and SW12 by the control unit 102, and does not necessarily have to be a switching command to the quick charging mode defined in IEC61851.

The power storage element B2 is a rechargeable power storage element such as a secondary battery or an electric double layer capacitor. The power storage element B2 supplies an operating power source voltage to respective parts in the connection circuit unit 7 including the communication unit 71.

The positive electrode of the storage element B2 is connected to the cathode of the diode D2, and the anode of the diode D2 is connected to the positive electrode of the power source B3 via the switch SW3, the wiring L3, and the DCDC converter 54. The negative electrode of power storage element B2 is connected to the negative electrode of power source B3 via the switch SW4, the wiring L4, and the DCDC converter 54.

The switch SW5 is turned on/off in conjunction with the operation lever 22. The switch SW5 is turned off when the operation lever 22 is in the ON posture, and is turned on when the operation lever 22 is in the OFF posture. One end of the switch SW5 is connected to the NAND gate 72, and the other end of the switch SW5 is connected to the circuit ground SGND. One end of the switch SW5 is pulled up by the resistor R4.

The NAND gate 72 controls ON/OFF of the switches SW1 to SW4. Specifically, the switches SW1 to SW4 are turned off when the output of the NAND gate 72 is at a high level, and the switches SW1 to SW4 are turned on when the output of the NAND gate 72 is at a low level.

Therefore, when the user grips the operation lever 22 and brings the operation lever 22 to the OFF posture, the switch SW5 is turned on, the output of the NAND gate 72 is set to the high level, and the switches SW1 to SW4 are turned off.

As a result, when the user grips the operation lever 22, that is, when gripping the grip portion 3, the switches SW1 to SW4 are turned off, and the wirings L1 to L4 passing through the grip portion 3 are electrically disconnected from to the connection circuit unit 7. As a result, the safety of the battery impedance measuring device 1 is improved.

A portion of the connection circuit unit 7 excluding the connector 21 is covered with a conductive shield 24 such as metal. The shield 24 is connected to the ground terminal TE. When the connector 21 is connected to the charging connector 101, the shield 24 is grounded for safety via the ground terminals TE and TCE.

The terminal Tp is connected to the terminal Tm via the resistors R1 and R2. The ground fault detector 73 has one end grounded via the shield 24 and the other end connected via the resistor R3 to an intermediate point between the resistors R1 and R2. That is, the ground fault detector 73 detects a ground fault or electric leakage between the terminals Tp and Tm connected to the secondary battery B1 of the electric motor vehicle 100 and the ground.

The ground fault detector 73 outputs a detection signal (low level) to the NAND gate 72 when a preset determination condition is satisfied, for example, when the detection current is 10 mA or more and continues for 800 msec or more. Then, the NAND gate 72 outputs a high level output signal to the switches SW1 to SW4, and the switches SW1 to SW4 are turned off.

That is, the ground fault detector 73 turns off the switches SW1 to SW4 when the preset determination condition is satisfied, and the wirings L1 to L4 passing through the grip portion 3 are electrically disconnected from the connection circuit unit 7. As a result, the safety of the battery impedance measuring device 1 is improved.

The NAND gate 72 outputs a low level signal and turns on the switches SW1 to SW4 only when the switch SW5 is off and the output of the ground fault detector 73 is high level. That is, the NAND gate 72 turns on the switches SW1 to SW4 only when the user does not hold the operation lever 22 and neither the ground fault nor the electric leakage occurs, so that the safety is improved.

Normally, when the battery impedance measuring device 1 is not connected to the electric motor vehicle 100, that is, in a storage state, etc., the user does not hold the operation lever 22 and the ground fault detector 73 does not detect a ground fault or electric leakage. At this time, the switches SW1 to SW4 are turned on. Therefore, the charging current is supplied from the power source B3 to the storage element B2 via the DCDC converter 54, the switches SW3 and SW4, and the diode D2, and the storage element B2 is charged.

Next, the operation of the battery impedance measuring device 1 when measuring the impedance of the secondary battery B1 will be described.

First, when the battery impedance measuring device 1 is stored, the storage element B2 is charged as described above. Next, when the user lifts the battery impedance measuring device 1 by holding the operation lever 22 to connect the battery impedance measuring device 1 to the electric motor vehicle 100, the switch SW5 and the NAND gate 72 turn off the switches SW1 to SW4.

Here, even if the switches SW1 to SW4 are turned off and the connection circuit unit 7 is electrically disconnected from the main body unit 5, since the connection circuit unit 7 includes the storage element B2, the safety circuits such as the ground fault detector 73, the resistor R4, the switch SW, and the NAND gate 72 are continuously operable with the communication unit 71. In addition, by using not the AC power source but the storage element B2 that is not grounded as the power source for operating the connection circuit unit 7, there is no bypass from the secondary battery B1 to the ground via the AC power source. As a result, the safety is improved.

Even if the user connects the connector 21 to the charging connector 101 in this state, the switches SW1 to SW4 are turned off, and the wirings L1 to L4 in the grip portion 3 held by the user are electrically disconnected from the connection circuit unit 7. Therefore, the safety is improved.

When the user releases the grip portion 3 with the connector 21 fixed to the charging connector 101, the operation lever 22 changes its posture to the ON posture, and the switches SW1 to SW4 are turned on by the switch SW5 and the NAND gate 72. As a result, each part of the main body unit 5 is connected to the connection circuit unit 7. At this time, the switches SW11 and SW12 are turned off on the electric motor vehicle 100 side.

Then, for example, when the communication unit 71 detects that the connector 21 is connected to the charging connector 101, the communication unit 71 transmits a switching command to the quick charging mode to the control unit 102, and the control unit 102 turns on the switches SW11 and SW12. As a result, the secondary battery B1 is connected to the main body unit 5 via the connection circuit unit 7, and the impedance of the secondary battery B1 can be measured.

The AC signal supply unit 51 outputs an AC signal to a signal path that reaches the measurement unit 52 via the switch SW2, the capacitor C2, the terminal Tm, the charging terminal TCm, the switch SW12, the secondary battery B1, the switch SW11, the diode D1, the charging terminal TCp, the terminal Tp, the capacitor C1, and the switch SW1, and returns to the circuit ground SGND of the measurement unit 52. As a result, the AC signal supply unit 51 supplies an AC signal to the secondary battery B1 via the capacitors C1 and C2.

The AC signal output from the AC signal supply unit 51 flows through the electrostatic capacitance of the diode D1. The diode D1 needs to have a sufficiently high breakdown voltage with respect to the output voltage of the secondary battery B1, for example, about 1,000 V. In general, a diode having a high breakdown voltage has an increased electrostatic capacitance. Therefore, the diode D1 can easily pass the AC signal in the reverse direction.

The capacitors C1 and C2 have a breakdown voltage sufficiently high with respect to the output voltage of the secondary battery B1, for example, a rated voltage of 1,000 V. The electrostatic capacitances of the capacitors C1 and C2 are set to have sufficiently low impedance with respect to the AC signal output from the AC signal supply unit 51, for example, a capacitance of about 1 µF.

The signal reaching the measurement unit 52 changes in phase, peak value, waveform, etc. from the AC signal output from the AC signal supply unit 51 due to the influence of the impedance of the secondary battery B1 and the like. The measurement unit 52 can measure the impedance of the secondary battery B1 based on this signal.

Here, since the capacitors C1 and C2 have low impedance with respect to the AC signal, the AC signal flows but the DC voltage does not flow. Therefore, even when the switches SW1 and SW2 are turned on, or even when the switches SW1 and SW2 have a failure such as in welding, the DC current output of the secondary battery B1 does not flow to the wirings L1 and L2 in the grip portion 3 that the user grasps, and also does not flow to the main body unit 5.

Therefore, the battery impedance measuring device 1 can improve the safety while measuring the impedance of the secondary battery B1.

Although FIG. 3 illustrates an example in which the AC signal supply unit 51 is connected to the negative electrode side of the secondary battery B1 and an AC signal flows in the direction from the terminal Tm toward the terminal Tp, the AC signal supply unit 51 may be connected to the positive electrode side of the secondary battery B1, and the AC signal may flow in the direction from the terminal Tp toward the terminal Tm.

However, connecting the AC signal supply unit 51 to the negative electrode side of the secondary battery B1 and making the AC signal flow in the direction from the terminal Tm to the terminal Tp can reduce the influence of the resistor R7 and the inductor L on the measurement accuracy, so it is more preferable.

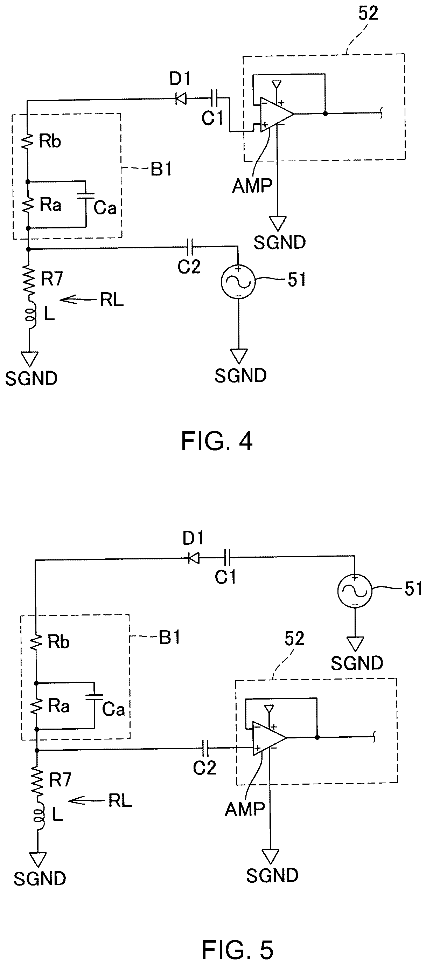

FIG. 4 is a circuit diagram illustrating the circuit illustrated in FIG. 3 in a simplified manner. FIG. 5 is a circuit diagram schematically illustrating a circuit in the case where the AC signal supply unit 51 is connected to the positive electrode side of the secondary battery B1 and the AC signal is caused to flow in the direction from the terminal Tp to the terminal Tm.

As illustrated in FIGS. 4 and 5, the secondary battery B1 is represented by an equivalent circuit in which a parallel circuit of a resistor Ra and a capacitor Ca and a resistor Rb are connected in series. In FIGS. 4 and 5, only an operational amplifier AMP at the input stage is illustrated for the measurement unit 52.

First, as illustrated in FIGS. 3 and 4, when the AC signal supply unit 51 is connected to the negative electrode side of the secondary battery B1, the secondary battery B1 to be measured and the series circuit RL of the resistor R7 and the inductor L are connected in parallel when viewed from the AC signal supply unit 51. In this case, as the resistance value of the resistor R7 is increased, the AC current flowing through the series circuit RL is reduced, and the influence on the measurement accuracy of the series circuit RL is reduced. If the resistor R7 is set to a sufficiently large value with respect to the internal resistors Ra and Rb of the secondary battery B1, the influence of the series circuit RL can be ignored.

The resistance values of the internal resistors Ra and Rb are usually about several tens Ω to several hundred Ω. As described above, it is desirable that the resistor R7 have a high resistance, and it is easy to set the resistance value that is sufficiently large with respect to several tens Ω to several hundred Ω, for example, the resistor R7 to about 1 MΩ. Since the resistor R7 only needs to have a resistance value that does not allow the secondary battery B1 to float, when the AC signal supply unit 51 is connected to the negative electrode side of the secondary battery B1, the resistor R7 has a large resistance value, so that this makes it easy to set and reduce the influence.

On the other hand, when the AC signal supply unit 51 is connected to the positive electrode side of the secondary battery B1, the secondary battery B1 to be measured and the series circuit RL are in a series connection relationship when viewed from the AC signal supply unit 51 as illustrated in FIG. 5. The measurement unit 52 detects a signal obtained from the secondary battery B1 via the terminal Tm and the capacitor C2.

In this case, the measurement unit 52 detects the voltage divided by the secondary battery B1 and the series circuit RL, and the voltage division ratio of the series circuit RL becomes high as the resistor R7 increases. That is, in order to reduce the influence of the series circuit RL, it is necessary to reduce the resistance value of the resistor R7.

However, if the resistance value of the resistor R7 is reduced, the secondary battery B1 and the circuit ground SGND are coupled with low resistance, and the insulation between the high voltage secondary battery B1 and the low voltage battery impedance measuring device 1 is difficult to secure. Therefore, when the AC signal supply unit 51 is connected to the positive electrode side of the secondary battery B1, it is difficult to reduce the influence on the measurement accuracy of the series circuit RL.

Therefore, it is more preferable to connect the AC signal supply unit 51 to the negative electrode side of the secondary battery B1 rather than to connect it to the positive electrode side.

In addition, it is preferable that the wiring of each part in the battery impedance measuring device 1 be configured by a coaxial cable and the shield thereof be connected to the circuit ground SGND. Thereby, the influence of noise is reduced and each wiring is insulated by the insulating coating of the coaxial cable, so that the safety is further improved.

Further, the operation lever 22 and the switch SW5 may not be provided, or the ground fault detector 73 may not be provided. Alternatively, the switches SW1 to SW5 may not be provided.

Further, the battery impedance measuring device 1 does not necessarily have to include the diagnosis unit 53, and may be configured to notify the impedance measured by the measurement unit 52 by displaying it on the touch panel display 56 or the like. Further, the secondary battery B1 is not limited to the power battery mounted on the electric motor vehicle. The secondary battery B1 may be used for various purposes such as an energy storage device for stabilizing electric power of renewable energy.

That is, a battery impedance measuring device according to an example of the invention includes a connection circuit unit that includes a positive electrode terminal that is detachable from a positive electrode charging terminal for charging a secondary battery provided outside, a negative electrode terminal that is detachable from a negative electrode charging terminal for charging the secondary battery, a first capacitor that is connected to the positive electrode terminal, and a second capacitor that is connected to the negative electrode terminal, and a main body unit that includes an AC signal supply unit that supplies an AC signal to the secondary battery via at least one of the first and second capacitors, and a measurement unit that detects at least one of a signal obtained from the secondary battery via the positive electrode terminal and the first capacitor and a signal obtained from the secondary battery via the negative electrode terminal and the second capacitor, and measures impedance of the secondary battery based on the detected signal.

According to this configuration, the AC signal is supplied from the AC signal supply unit to the secondary battery via the first and second capacitors. Then, the measurement unit measures the impedance of the secondary battery based on at least one of the signal obtained from the secondary battery via the positive electrode terminal and the first capacitor, and the signal obtained from the secondary battery via the negative electrode terminal and the second capacitor. Here, the first and second capacitors allow an AC signal to pass but do not allow a DC current to flow. Therefore, since the DC current from the secondary battery does not flow in the path from the first and second capacitors to the AC signal supply unit and the measurement unit, the safety of the battery impedance measuring device is improved.

Also, there are provided a connection housing that stores the connection circuit unit, a grip portion that is connected to the connection housing and can be gripped by a user, first wiring that connects the first capacitor to the main body unit, and second wiring that connects the second capacitor to the main body unit. The first and second wirings are connected to the main body unit through an inside of the grip portion.

According to this configuration, the connection circuit unit from the positive and negative electrode terminals to the first and second capacitors is stored in the connection housing, and the first and second wirings connected to the first and second capacitors pass though the inside of the grip portion that can be gripped by the user. The first and second capacitors prevent the DC current from the secondary battery from flowing through the first and second wirings inside the gripping portion that is held by the user, so that the safety of the battery impedance measuring device is improved.

Further, it is preferable that the grip portion further accommodate the main body unit.

According to this configuration, the safety of the battery impedance measuring device is improved, the portability of the battery impedance measuring device is improved, and the handling becomes easy.

Further, the connection housing includes an operation lever attached on the connection housing which extends toward the grip portion and is capable of changing a posture between an OFF posture approaching the grip portion and an ON posture farther away from the grip portion than the OFF posture. The connection circuit unit further includes a first switch that turns on and off connection between the first capacitor and the first wiring, a second switch that turns on and off connection between the second capacitor and the second wiring, and an open/close switch that turns on the first and second switches when the operation lever is in the ON posture, and turns off the first and second switches when the operation lever is in the OFF posture.

According to this configuration, when the user grips the operation lever together with the grip portion, the operation lever is in the OFF posture, and the first and second capacitors and the first and second wirings are electrically disconnected. As a result, the safety of the battery impedance measuring device is further improved.

Further, the connection circuit unit further includes a storage element that outputs electric power for operating the connection circuit unit, and a third switch that opens and closes a charging current for charging the storage element. The main body unit further includes a power source unit that supplies a charging current of the storage element via the third switch. The open/close switch further turns on the third switch when the operation lever is in the ON posture and turns off the third switch when the operation lever is in the OFF posture.

According to this configuration, when the user does not grip the operation lever and the operation lever is in the ON posture, the third switch is turned on and the power storage element is charged. On the other hand, when the user grips the operation lever and brings the operation lever to the OFF posture, the third switch is turned off to insulate the connection circuit unit and the main body unit, thereby improving the safety. At this time, since the charged storage element is provided in the connection circuit unit, even if the third switch is turned off, the connection circuit unit can be operated by the output power of the storage element.

Further, the connection circuit unit further may include a first switch that turns on and off connection between the first capacitor and the first wiring, a second switch that turns on and off connection between the second capacitor and the second wiring, a ground terminal for being grounded, and a ground fault detection unit that turns off the first and second switches when a current flowing between the ground terminal and the positive electrode terminal and the negative electrode terminal satisfies a predetermined determination condition.

According to this configuration, the first and second capacitors and the first and second wirings are electrically disconnected when the ground fault detection unit or the electric leakage occurs. As a result, the safety of the battery impedance measuring device is further improved.

Further, the connection circuit unit is provided with, in the outside, a switching unit which switches whether the positive electrode charging terminal and the negative electrode charging terminal and the secondary battery are electrically connected. The connection circuit unit further includes a communication unit that transmits, by the switching unit, a switching command for electrically connecting the positive electrode charging terminal and the negative electrode charging terminal to the secondary battery.

According to this configuration, even when the secondary battery is separated from the positive electrode charging terminal and the negative electrode charging terminal by the switching unit, the positive electrode charging terminal and the negative electrode charging terminal can be electrically connected to the secondary battery by transmitting the switching command from the communication unit. As a result, the battery impedance measuring device can measure the impedance of the secondary battery.

Further, it is preferable that the switching command be a switching command to a quick charging mode defined by IEC61851.

The quick charging mode defined by IEC61851 is a mode in which the positive electrode charging terminal and the negative electrode charging terminal are electrically connected to the secondary battery to charge the secondary battery with the current supplied between the positive electrode charging terminal and the negative electrode charging terminal. Therefore, by transmitting the switching command to the quick charging mode defined by IEC61851 from the communication unit, the positive electrode charging terminal and the negative electrode charging terminal can be electrically connected to the secondary battery, and the impedance can be measured.

Further, it is preferable that the connection circuit unit further include a resistor that connects the negative electrode terminal to a circuit ground, and the AC signal supply unit flow the AC signal in a direction from the negative electrode terminal to the positive electrode terminal.

According to this configuration, since the resistor that connects the negative electrode terminal to the circuit ground is provided, it becomes easy to put the detection signal by the measurement unit within the measurement range of the measurement unit. Further, it is easy to set the resistance to a large resistance value and reduce the influence of the resistance on the measurement.

Further, the main body unit further includes a diagnosis unit that diagnoses deterioration of the secondary battery based on impedance measured by the measurement unit.

According to this configuration, the deterioration of the secondary battery can be diagnosed.

The battery impedance measuring device having such a configuration can improve safety.

This application is based on Japanese Patent Application No. 2018-143104 filed on July 31, 2018, the content of which is included in the present application. It should be noted that the specific embodiments or examples made in the modes for carrying out the invention are merely for clarifying the technical contents of the invention, and the invention is not limited only to such specific examples. It should not be construed in a narrow sense by limiting only.

### REFERENCE SIGNS LIST

- 1: battery impedance measuring device
- 2: connection housing
- 3: grip portion
- 4: cable
- 5: main body unit
- 7: connection circuit unit
- 21: connector
- 22: operation lever
- 23: hinge
- 24: shield
- 51: AC signal supply unit
- 52: measurement unit
- 53: diagnosis unit
- 54: DCDC converter
- 55: casing
- 56: touch panel display
- 71: communication unit
- 72: NAND gate
- 73: ground fault detector (ground fault detection unit)
- 100: electric motor vehicle
- 101: charging connector
- 102: control unit
- AMP: operational amplifier
- B1: secondary battery
- B2: storage element
- B3: power source
- C1: capacitor (first capacitor)
- C2: capacitor (second capacitor)
- Ca: capacitor
- D1, D2: diode
- EGND: earth ground
- L: inductor
- L1: wiring (first wiring)
- L2: wiring (second wiring)
- L3, L4: wire
- R1-R7,: Ra, Rb resistor
- RL: series circuit
- SGND: circuit ground
- SW1: switch (first switch)
- SW2: switch (second switch)
- SW3, SW4: switch (third switch)
- SW5: switch (open/close switch)
- SW11, SW12: switch (switching unit)
- TCE: ground terminal
- TCH, TCL: communication terminal
- TCm: charging terminal (negative electrode charging terminal)
- TCp: charging terminal (positive electrode charging terminal)
- TE, TCE: ground terminal
- TH, TL: communication terminal
- Tm: terminal (negative electrode terminal)
- Tp: terminal (positive electrode terminal)

## Claims

1. A battery impedance measuring device, comprising:
a connection circuit unit that includes
a positive electrode terminal that is detachable from a positive electrode charging terminal for charging a secondary battery provided outside,
a negative electrode terminal that is detachable from a negative electrode charging terminal for charging the secondary battery,
a first capacitor that is connected to the positive electrode terminal, and
a second capacitor that is connected to the negative electrode terminal; and
a main body unit that includes
an AC signal supply unit that supplies an AC signal to the secondary battery via at least one of the first and second capacitors, and
a measurement unit that detects at least one of a signal obtained from the secondary battery via the positive electrode terminal and the first capacitor and a signal obtained from the secondary battery via the negative electrode terminal and the second capacitor, and measures impedance of the secondary battery based on the detected signal.

2. The battery impedance measuring device according to claim 1, further comprising:
a connection housing that stores the connection circuit unit;
a grip portion that is connected to the connection housing and can be gripped by a user;
first wiring that connects the first capacitor to the main body unit; and
second wiring that connects the second capacitor to the main body unit,
wherein the first wiring and second wiring are connected to the main body unit through an inside of the grip portion.

3. The battery impedance measuring device according to claim 2,
wherein the grip portion further stores the main body unit.

4. The battery impedance measuring device according to claim 2 or 3,
wherein the connection housing includes an operation lever attached on the connection housing which extends toward the grip portion and is capable of changing a posture between an OFF posture approaching the grip portion and an ON posture farther away from the grip portion than the OFF posture, and
wherein the connection circuit unit further includes
a first switch that turns on and off connection between the first capacitor and the first wiring,
a second switch that turns on and off connection between the second capacitor and the second wiring, and
an open/close switch that turns on the first and second switches when the operation lever is in the ON posture, and turns off the first and second switches when the operation lever is in the OFF posture.

5. The battery impedance measuring device according to claim 4,
wherein the connection circuit unit further includes
a storage element that outputs electric power for operating the connection circuit unit, and
a third switch that opens and closes a charging current for charging the storage element, wherein the main body unit further includes a power source unit that supplies a charging current of the storage element via the third switch, and
wherein the open/close switch further turns on the third switch when the operation lever is in the ON posture and turns off the third switch when the operation lever is in the OFF posture.

6. The battery impedance measuring device according to any one of claims 1 to 5,
wherein the connection circuit unit further includes
a first switch that turns on and off connection between the first capacitor and the first wiring,
a second switch that turns on and off connection between the second capacitor and the second wiring,
a ground terminal for being grounded, and
a ground fault detection unit that turns off the first and second switches when a current flowing between the ground terminal and the positive electrode terminal and the negative electrode terminal satisfies a predetermined determination condition.

7. The battery impedance measuring device according to any one of claims 1 to 6,
wherein, in the outside, a switching unit is provided which switches whether the positive electrode charging terminal and the negative electrode charging terminal and the secondary battery are electrically connected, and
wherein the connection circuit unit further includes a communication unit that transmits, by the switching unit, a switching command for electrically connecting the positive electrode charging terminal and the negative electrode charging terminal to the secondary battery.

8. The battery impedance measuring device according to claim 7,
wherein the switching command is a switching command to a quick charging mode defined by IEC61851.

9. The battery impedance measuring device according to any one of claims 1 to 8,
wherein the connection circuit unit further includes a resistor that connects the negative electrode terminal to a circuit ground, and
wherein the AC signal supply unit causes the AC signal to flow in a direction from the negative electrode terminal to the positive electrode terminal.

10. The battery impedance measuring device according to any one of claims 1 to 9,
wherein the main body unit further includes a diagnosis unit that diagnoses deterioration of the secondary battery based on impedance measured by the measurement unit.
